(19) Europäisches Patentamt
European Patent Office
Office européen des brevets

(11) EP 2 135 971 B1

(12) **EUROPEAN PATENT SPECIFICATION**

(45) Date of publication and mention of the grant of the patent:
**11.05.2016 Bulletin 2016/19**

(21) Application number: **08739601.6**

(22) Date of filing: **01.04.2008**

(51) Int Cl.:
***C23C 14/12*** (2006.01) ***C08G 18/08*** (2006.01)
***C08G 18/32*** (2006.01) ***C08G 18/75*** (2006.01)
***C08G 18/76*** (2006.01) ***C09D 175/02*** (2006.01)
***B05D 1/00*** (2006.01)

(86) International application number:
**PCT/JP2008/056488**

(87) International publication number:
**WO 2008/129925 (30.10.2008 Gazette 2008/44)**

(54) **POLYUREA FILM AND METHOD OF FORMING THE SAME**

POLYHARNSTOFFFILM UND VERFAHREN ZU SEINER HERSTELLUNG

FILM POLYURÉE ET SON PROCÉDÉ DE FORMATION

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **16.04.2007 JP 2007106898**

(43) Date of publication of application:
**23.12.2009 Bulletin 2009/52**

(73) Proprietors:
- **ULVAC, INC.**
  **Chigasaki-shi**
  **Kanagawa 253-8543 (JP)**
- **Kojima Press Industry Co., Ltd.**
  **Toyota-shi,**
  **Aichi-ken 471-8588 (JP)**

(72) Inventors:
- **IRIKURA, Hagane**
  **Tsukuba-shi**
  **Ibaraki 300-2635 (JP)**
- **OMORI, Daisuke**
  **Tsukuba-shi**
  **Ibaraki 300-2635 (JP)**
- **NOGUCHI, Masumi**
  **Toyota-shi**
  **Aichi 471-8588 (JP)**

(74) Representative: **Körber, Martin Hans**
**Mitscherlich PartmbB**
**Patent- und Rechtsanwälte**
**Sonnenstrasse 33**
**80331 München (DE)**

(56) References cited:
**EP-A2- 0 155 823** **EP-A2- 1 460 697**
**WO-A1-2006/101171** **WO-A1-2007/129643**
**JP-A- 05 177 163** **JP-A- 05 311 399**
**JP-A- 07 258 370** **JP-A- 2007 134 099**
**JP-A- 2008 056 790**

- **FUKADA: "Recent developments of polar piezoelectric polymers", IEEE TRANSACTIONS ON DIELECTRICS AND ELECTRICAL INSULATION, IEEE SERVICE CENTER, PISCATAWAY, NJ, US, vol. 13, no. 5, 1 October 2006 (2006-10-01), pages 1110-1119, XP011142348, ISSN: 1070-9878**
- **NAKAZAWA M ET AL: "A high frequency variable focus ultrasonic transducer using polyurea thin film", ULTRASONICS SYMPOSIUM, 2005 IEEE ROTTERDAM, THE NETHERLANDS 18-21 SEPT. 2005, PISCATAWAY, NJ, USA,IEEE, vol. 4, 18 September 2005 (2005-09-18), pages 2313-2316, XP010899337, DOI: 10.1109/ULTSYM.2005.1603347 ISBN: 978-0-7803-9382-0**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 135 971 B1

- **HATTORI T. ET AL.: 'Piezoelectric and ferroelectric properties of polyurea-5 thin films prepared by vapor deposition polymerization' JOURNAL OF APPLIED PHYSICS vol. 79, no. 3, 01 February 1996, pages 1713 - 1721, XP008113882**

## Description

Technical Field

The present invention relates to a method for preparing a polyurea film on a substrate by a method of vacuum deposition polymerization.

Background of the Invention

Polyurea films have conventionally been prepared via the reaction between diamines and diisocyanates as shown in the following chemical formula 1, for which the methods described below in (a) to (d) are listed.

(a) Patent reference 1 describes a method for preparing a synthetic resin film (vacuum deposition polymerization method) comprising vaporizing two types or more of raw material monomers in a vacuum processing chamber and polymerizing the monomers together on a substrate. The patent reference herein describes that the raw material monomers are sequentially polymerized together (polymerization condensation/addition polymerization) to prepare a polyurea (urea resin) film comprising 4,4'-diphenylmethane diisocyanate (aromatic diisocyanate) and 4,4'-diaminodiphenyl ether (aromatic diamine).

(b) Patent reference 2 describes that a transparent film is prepared by vapor deposition polymerization on an ornament with a metal film or with a metal compound film. Specifically, the patent reference describes a polyurea film comprising 4,4'-diphenylmethane diisocyanate (aromatic family) and 4.4'-diaminophenyl ether (aromatic family), or a polyurea film comprising 4,4'-diphenylmethane diisocyanate (aromatic family) and 4,4'-diamino-3,3'-dimethyldiphenyl methane (aromatic family), or a polyurea film comprising 4,4'-diisocyanate-3,3'-dimethyldiphenyl (aromatic family) and 4,4'-diphneylmethanediamine (aromatic family).

(c) Patent reference 3 describes that polyurea is prepared by vapor deposition polymerization, using an aliphatic diisocyanate and an aliphatic diamine as raw material monomers. The patent reference herein describes that a polyurea film is prepared by polymerization of for example 1,9-diisocyanate nonane (aliphatic family) and 1,9-diaminononane (aliphatic family), while a substrate is retained at a state of low temperature of 0°C or less.

(d) Patent reference 4 describes that in case of using a combination of monomers with low reactivity, energy required for the reaction is supplied to the raw material monomers on a substrate to prepare a film. The patent reference describes that a substrate is heated so as to supply the energy and that in case of a polyurethane film, the temperature of the substrate is 90°C and in case of a polyester film, the temperature of the substrate is 130°C.

In case that a polyurea film is to be prepared by vacuum deposition polymerization methods like the methods described above in (a) and (b), characteristically, aromatic diisocyanates and aromatic diamines are commonly used as raw material monomers and the resulting polyurea film is colorless and transparent. Over time and via ultraviolet exposure, disadvantageously, aromatic polyurea is discolored (after accelerated weatherability test: $\Delta E = 29.45$). As shown in Fig. 1, disadvantageously, aromatic polyurea cannot be used for film articles toward which transparency is demanded, because the aromatic isocyanate as the terminal group of the film reacts with water to generate aniline (Fig. 1(a)) and then, the aniline reacts with oxygen to produce aniline black (Fig. 1(b)), leading to discoloration.

In case of using monomers with low reactivity for vapor deposition polymerization as in the methods described above in (c) and (d), in contrast to the aforementioned methods, it is considered that diisocyanates and diamines of aromatic alkyl-, alicyclic- or aliphatic families (in structures never generating aniline black) are used as raw material monomers to prepare a transparent film. Since these raw material monomers are at low reactivity, two types of such monomers may not react together but may be deposited on a substrate so that a desired film cannot be prepared or the resulting composition is variable leading to the generation of a non-uniform film. Therefore, the application of these methods to mass-scale products involved much difficulty.

By the methods described above in (c) and (d), further, the temperature of the substrate therefor should essentially be lowered or raised. In case that the substrate is a metal or an inorganic material (with great heat transfer properties without softening, plasticization and carbonization at high temperature, which occur in resins) or in case that substrate 1 fixed with a substrate-fixing device 1 is in a flat and thin form as shown in Fig. 2(a) (the substrate can be cooled uniformly with the substrate-fixing device or a cooling source therearound or can be heated uniformly with a heat source), the substrate temperature is possibly controlled. In case of a resin-molded article of a steric structure on the surface of substrate 2 as shown in Fig. 2(b) (referred to as "resin-molded article"), however, it is very hard to retain the temperature of the substrate surface constantly or control the substrate temperature, disadvantageously.

Patent reference 1: the publication of JP-A-61-078463
Patent reference 2: the publication of JP-A-03-097849

Patent reference 3: the publication of JP-A-08-283932
Patent reference 4: the publication of JP-A-09-278805

Disclosure of the Invention

Problem that the Invention is to Solve

It is an object of the invention to provide a method for preparing, a polyurea film with good transparency, light resistance and mass-scale productivity.

Means for Solving the Problems

So as to solve the problem, the present inventors made investigations. Consequently, the inventors found the following approach could solve the problem, based on the finding that via a combination of a specific diisocyanate and a specific diamine monomer when used, a polyurea film with good transparency and light resistance could be obtained.
The polyurea film according to the claim 2 is the polyurea film according to the claim 1, where the diisocyanate monomer is 1,3-bis(1-isocyanate-1-methylethyl)benzene and the diamine monomer is 1,3-bis(aminomethyl)cyclohexane.
The polyurea film according to the claim 3 is the polyurea film according to the claim 1, where the diisocyanate monomer is 1,3-bis(isocyanatemethyl)cyclohexane and the diamine monomer is any of methylenebis(4-cyclohexylamine). N,N-bis(3-aminopropyl)piperazine, 1,12-diaminododecane, and 1,3-bis(aminomethyl)benzene.
The polyurea film according to the claim 4 is the polyurea film according to the claim 1, where the diisocyanate monomer is 1,3-bis(isocyanatemethyl)benzene and the diamine monomer is 1,12-diaminododecane.
Specifically, the method for preparing a polyurea film in accordance with the invention is a method as described in the claims.

Advantages of the Invention

In accordance with the method of invention, a polyurea film with no variation of the composition can be prepared even for resin-molded articles with good transparency, hardness, impact resistance, chemical resistance, wear resistance and durability and with a steric shape on the surface thereof.

Brief Description of Drawings

[Fig. 1] Explanatory view for explaining the cause of the discoloration of conventional polyurea films.
[Fig. 2] Explanatory view for explaining inconvenience during the preparation of conventional polyurea films.
[Fig. 3] Graphs depicting examples of measured weight loss (TG measurement) of a monomer.
[Fig. 4] Graphs depicting vapor pressure P at temperature T of the monomer.
[Fig. 5] Graphs depicting the retention time of the monomer on a substrate.
[Fig. 6] Graphs depicting the relation of the activation energies of individual monomers.
[Fig. 7] Graphs depicting the relation of the retention times of individual monomers.
[Fig. 8] Explanatory photograph of a polyurea film prepared in one example with the method of the invention.
[Fig. 9] IR chart regarding the evaluation of the variation in the Example.

Description of Symbols

1. Substrate-fixing device
2. Substrate

Best Mode for Carrying out the Invention

In accordance with the invention, an aromatic alkyl diisocyanate represented for example by Chemical Formula 2, an alicyclic diisocyanate represented for example by Chemical Formula 3, or an aliphatic diisocyanate represented for example by Chemical Formula 4 is used as the raw material monomer diisocyanate.

[Chemical Formula 2]

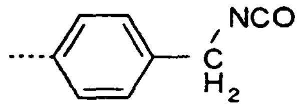

[Chemical Formula 3]

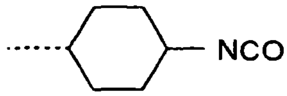

[Chemical Formula 4]

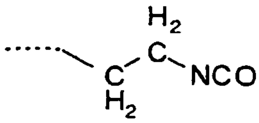

As the diamine as the raw material monomer, an aromatic alkyl diamine represented for example by Chemical Formula 5, an alicyclic diamine represented for example by Chemical Formula 6, or an aliphatic diamine represented for example by Chemical Formula 7 is used.

[Chemical Formula 5]

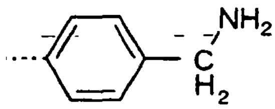

[Chemical Formula 6]

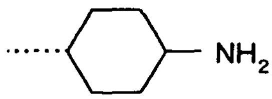

[Chemical Formula 7]

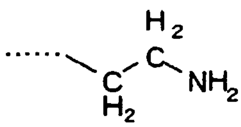

By vaporizing these raw material monomers in vacuum and polymerizing the monomers together on a substrate, a polyurea film with good transparency and light resistance can be prepared. Further, the vacuum pressure is not specifically limited but is generally about $10^{-3}$ to 100 Pa.

The raw material monomers are vaporized in vacuum to repeat adsorption and elimination on a substrate. So as to prepare a film on a substrate, these raw material monomers essentially react together to be polymerized together on a substrate. In the vapor deposition polymerization method, in other words, the retention time of raw material monomers on a substrate (the activation energy required for the elimination) and the reactivity between the raw material monomers (the activation energy for the reaction) have great influence. Compared with a combination of monomers (aromatic

family) with high reactivity (small activation energy for the reaction), a combination of monomers (aromatic alkyl-, alicyclic- or aliphatic family) with low reactivity (large activation energy for the reaction) is more highly influenced by the retention time of the raw material monomers on a substrate (the activation energy required for the elimination). Therefore, the combination of monomers (aromatic alkyl-, alicyclic- or aliphatic family) with low reactivity (large activation energy for the reaction) is seriously influenced by a slight change of any condition with influences on the retention time of the raw material monomers on a substrate, including substrate temperature, the vapor pressures of the monomers and the temperature and vacuum degree of atmosphere where the processing is done, so that the polymerization of these monomers at a constant composition ratio on a substrate involves much difficulty.

In accordance with the invention, therefore, such monomers are selected by the following method.

The weight loss of a monomer when heated in vacuum is measured (TG measurement) (Fig. 3) to determine the vapor pressure P (Fig. 4) at temperature T according to the Langmuir' s equation:

$$P = 228.3m(T/M)^{1/2}$$

where

P: saturated vapor pressure (Pa) at temperature T;
m: vaporization velocity (dΔW/dt)/U
U: area with the occurrence of vaporization; M: gram-molecular weight of vaporizing molecule; R: gas constant; T: temperature (K) of vaporizing face.

According to the following Clausius-Clapeyron's Equation, then, the activation energy required for the elimination (Fig. 4) and the retention time of the monomer on the substrate (Fig. 5) (see "Vapor Pressure and Mean Adsorption Time of PMDA and ODA", Japanese Journal of Applied Physics, Vol. 38 (1999) pp. L687 - L690) are determined:

$$\log P = A - \Delta H/RT$$

$$\tau = \tau_0 \exp(Ed/RT)$$

ΔH: activation energy; τ: retention time (seconds); $\tau_0$: $4.6 \times 10^{-17}$.

Individual monomers are selected so as to satisfy the relation such that the difference in the activation energy required for the elimination from a substrate between a diisocyanate monomer and a diamine monomer is 10 kJ or less (Fig. 6). When the difference exceeds 10 kJ, the influence of the change of the substrate temperature sometimes causes difficulty in preparing a polyurea film at a constant composition ratio.

In other words, individual monomers are selected in a manner such that by determining the ratio of the change of the retention time of a monomer on a substrate to the change of the temperature of the substrate, the difference in the ratio of the changes between a monomer with a small such ratio of the changes and a monomer with a large such ratio of the changes is 20 % or less (Fig. 7).

As shown in the figure of a certain monomer, specifically, the reciprocal of the temperature of a substrate, namely 1/T ($K^{-1}$) is shown on the crosswise axis, while on the longitudinal axis, the retention time of the monomer on the substrate, namely τ (s) is shown. Then, the slope k of the graph, namely (τ/(1/T)) is determined. The slope k1 of the graph of a diisocyanate monomer for use in vacuum deposition and the slope k2 of a diamine monomer for use therein are determined (for description, herein, k1 > k2 on assumption; thus, k1 is the basal ratio of the changes). When [1-(k1-k2)] is 20 % or less, subsequently, the diamine monomer with k2 is selected for the diisocyanate monomer with k1.

Via a combination of the diisocyanate monomer and the diamine monomer as selected by the two methods described above, a film of a uniform composition can be prepared from such raw material monomers with low reactivity, without any need of controlling the substrate temperature or under not any influence of inter-batch conditions (for example, conditions between the first and second film preparations), such as monomer vapor pressure, and the temperature and vacuum degree of the atmosphere for the processing.

Any raw material monomer satisfying the conditions described above may be used as the raw material monomer in accordance with the invention, with no specific limitation. Specific examples thereof are as follows.

<Diisocyanates>

Aromatic alkyl: 1,3-bis(isocyanatemethyl)benzene, 1,3-bis(1-isocyanate-1-methylethyl)benzene, etc. Alicyclic: 1,3-bis(isocyanatemethyl)cyclohexane, 3-isocyanatemethyl-3,5,5-trimethylhexylisocyanate, methylenebis(4-cyclohexylisocyanate),

2,5(2,6)-bis(isocyanatemethyl)bicycle[2,2,1]heptane, etc. Aliphatic: 1,6-diisocyanate hexane, 1,5-diisocyanate-2-methyl pentane, 1,8-diisocyanate octane, 1,12-diisocyanate dodecane, tetraisocyanate silane, monomethyltriisocyanate silane, etc.

<Diamines>

Aromatic alkyl: 1,3-bis(aminomethyl)benzene, 1,4-bis(aminomethyl)benzene, isophthalic acid dihydrazide, etc.

Alicyclic: 1,3-bis(aminomethyl)cyclohexane, 1,4-bis(aminomethyl)cyclohexane, 3-aminomethyl-3,5,5-trimethylhexylamine,

1,2-diaminecyclohexane, 1,4-diaminocyclohexane, methylenebis(4-cyclohexylamine), piperazine, 2-piperazine, 2,5-dimethylpiperazine, 2,6-dimethylpiperazine, N,N'-bis(3-aminopropyl)piperazine,

1,3-di(4-piperidyl)propane, hydantoin, hexahydro-1H-1,4-diazepine, barbituric acid, etc. Aliphatic: 1,6-diaminohexane, 1,7-diaminoheptane, 1,8-diaminooctane, 1,9-diaminononane, 1,10-diaminodecane, 1,12-diaminododecane, bis(2-aminoethyl)amine, bis(3-aminopropyl)amine, N,N'-bis(aminopropyl)methylamine, N-(3-aminopropyl)-1,4-butanediamine,

N,N'-(3-aminopropyl)-1,4-butanediamine, adipic acid dihydrazide, dodecandioic acid dihydrazide, sebacic acid dihydrazide, etc.

Examples

So as to validate that the difference in the retention time of a raw material monomer on a substrate would influence film preparation by determining the vapor pressure P at the temperature T (on a vapor pressure curve) and the activation energy required for the elimination from the substrate, on the basis of the measurement results of the weight loss when the monomer was heated in vacuum, combinations of diisocyanates and diamines in Examples 1. to 6 and Comparative Example 1 were used for preparing polyurea films.

(Example 1)

Diisocyanate: 1,3-bis(1-isocyanate-1-methylethyl)benzene
Diamine: 1,3-bis(aminomethyl)cyclohexane

(Example 2)

Diisocyanate: 1,3-bis(isocyanatemethyl)cyclohexane
Diamine: methylenebis(4-cyclohexylamine)

(Example 3)

Diisocyanate: 1,3-bis(isocyanatemethyl)cyclohexane
Diamine: N,N-bis(3-aminopropyl)piperazine

(Example 4)

Diisocyanate: 1,3-bis(isocyanatemethyl)cyclohexane
Diamine: 1,12-diaminododecane

(Example 5)

Diisocyanate: 1,3-bis(isocyanatemethyl)cyclohexane
Diamine: 1,3-bis(aminomethyl)benzene

(Example 6)

Diisocyanate: 1,3-bis(isocyanatemethyl)benzene
Diamine: 1,12-diaminododecane

(Comparative Example 1)

Diisocyanate: 1,3-bis(isocyanatemethyl)benzene

Diamine: methylenebis(4-cyclohexylamine)

The results of experimental film preparations in Examples 1 to 6 and Comparative Example 1 are shown in Table 1.

TABLE 1

| | | Excellence in film preparation | | Transparency | Light resistance | Mass scale production |
|---|---|---|---|---|---|---|
| | Difference in activation energy for elimination (kJ) | appearance | Intra-sample compositional variation CV% | Transmission ratio % | ΔE | Inter-batch compositional variation CV% |
| Example 1 | 0.1 | ○ | 5.14 | More than 80 | 1.8 | 5.82 |
| Example 2 | 0.2 | ○ | 7.90 | More than 80 | 0.4 | 5.44 |
| Example 3 | 0.3 | ○ | 7.24 | More than 80 | 0.8 | 4.29 |
| Example 4 | 5.6 | ○ | 9.47 | More than 80 | 0.5 | 6.87 |
| Example 5 | 9.2 | ○ | 28.43 | More than 80 | 1.5 | 50.68 |
| Example 6 | 5.1 | ○ | 10.21 | More than 80 | 1.3 | 17.63 |
| Comparative Example 1 | 10.5 | × | 85.62 | - | - | - |

Based on the evaluation of the appearance, it was observed that polyurea films were prepared in Examples 1 to 6, while in Comparative Example 1, parts with prepared films and parts without any prepared films were observed as shown in Fig. 8.

Based on the evaluation of the variation in film composition at 10 positions in one sample, a larger variation of the film composition was observed as the difference in the activation energy for the elimination between raw material monomers in combination was larger. The variation of the film composition was determined by comparing the ratio of the area of isocyanate (-NCO) absorption to the area of amine ($-NH_2$) absorption at 10 positions, on IR charts obtained by FT-IR (Fourier Transform IR spectrometer) measurement immediately after the film preparation (see Fig. 7).

Based on the evaluation of the appearance and the examination of the variation of the film composition, it was validated that the difference in the retention time of a raw material monomer on a substrate (activation energy required for the elimination) influenced film preparation.

About possible combinations for preparing films, additionally, the transparency, light resistance and mass-scale productivity were examined. The results are shown in Table 1. The transparency was assessed by measuring the

transmission ratio of a sample of a film thickness of 20 $\mu$m within a visible range (400 nm to 800 nm) with an absorptiometer. A weatherability was evaluated by applying a sample to an accelerated light resistance tester of a carbon arc lamp type for 400 hours, to measure the color difference before and after the test. The mass-scale productivity was assessed by comparing the inter-batch variation of film composition (the variation between the first and second film preparations......) at the first to tenth tests, based on the results of the measurement with FT-IR.

It was found that when the difference in the activation energies required for the elimination of raw material monomers in combination was 10 kJ or less, polyurea films with excellent transparency, light resistance and mass-scale productivity could be prepared.

By the method for preparing a film in the Example, it was found that a film of a uniform composition could be prepared, without mounting any mechanism for controlling substrate temperature or without mounting any mechanism for eliminating the influence of an apparatus therefor or the environment therefor (monomer vapor pressure, temperature and vacuum degree of film preparation chamber) between batches (between the first and second film preparations, ......) in the apparatus therefor.

## Claims

1. A method for preparing a polyurea film by vacuum deposition polymerization of an aromatic alkyl-, alicyclic- or aliphatic diisocyanate monomer and an aromatic alkyl-, alicyclic- or aliphatic diamine monomer, where
the weight loss of the monomers when heated in vacuum is measured to determine a saturated vapor pressure P (unit: Pa) at a temperature T (unit: K) of a vaporizing face according to the following equation:

$$P = 228.3m(T/M)^{1/2}$$

wherein m is a vaporization velocity (d$\Delta$W/dt)/U, U is an area with the occurrence of vaporization, and M is a gram-molecular weight of vaporizing molecules;
wherein an activation energy $\Delta$H required for elimination and a retention time $\tau$ (s) of the monomers on a substrate are determined according to the following equations:

$$\log P = A - \Delta H/RT$$

$$\tau = \tau_0 \exp(Ed/RT)$$

wherein R is a gas constant and $\tau_0$ is $4.6 \times 10^{-17}$; and
individual monomers are selected so as to satisfy a relation such that the difference in the activation energy $\Delta$H required for the elimination from the substrate between the diisocyanate monomer and the diamine monomer is 10 kJ or less.

2. A method for preparing a polyurea film according to claim 1, where the diisocyanate monomer is 1,3-bis(1-isocyanate-1-methylethyl)benzene and the diamine monomer is 1,3-bis(aminomethyl)cyclohexane.

3. A method for preparing a polyurea film according to claim 1, where the diisocyanate monomer is 1,3-bis(isocyanatemethyl)cyclohexane and the diamine monomer is any of methylenebis(4-cyclohexylamine), N,N-bis(3-aminopropyl)piperazine, 1,12-diaminododecane and 1,3-bis(aminomethyl)benzene.

4. A method for preparing a polyurea film according to claim 1, where the diisocyanate monomer is 1,3-bis(isocyanatemethyl)benzene and the diamine monomer is 1,12-diaminododecane.

## Patentansprüche

1. Verfahren zur Herstellung eines Polyharnstofffilms durch Vakuumbedampfungs-Polymerisation eines aromatischen Alkyl-, alizyklischen oder aliphatischen Diisozyanat-Monomers und eines aromatischen Alkyl-, alizyklischen oder aliphatischen Diamin-Monomers,
wobei der Gewichtsverlust der Monomere, wenn sie im Vakuum erwärmt werden, gemessen wird, um einen gesättigten Dampfdruck P (Einheit: Pa) bei einer Temperatur (Einheit: K) einer Verdampfungsfläche gemäß der folgenden Gleichung zu bestimmen:

$$P = 228{,}3m(T/M)^{1/2},$$

worin m eine Verdampfungsgeschwindigkeit (dΔW/dt)/U ist, wobei U ein Bereich mit dem Auftreten der Verdampfung ist und wobei M ein Molgewicht von verdampfenden Molekülen ist,
wobei eine zur Ausscheidung erforderliche Aktivierungsenergie ΔH und eine Verweilzeit $\tau$(s) der Monomere auf einem Substrat gemäß den folgenden Gleichungen bestimmt werden:

$$\log P = A - \Delta H/RT$$
$$\tau = \tau_0 \exp(Ed/RT),$$

worin R eine Gaskonstante ist und worin $\tau_0$ 4,6 x $10^{-17}$ beträgt, und wobei einzelne Monomere ausgewählt werden, um einer Beziehung derart zu genügen, dass die Differenz in der für das Ausscheiden aus dem Substrat erforderlichen Aktivierungsenergie ΔH zwischen dem Diisozyanat-Monomer und dem Diamin-Monomer 10kJ oder weniger beträgt.

**2.** Verfahren zur Herstellung eines Polyharnstofffilms nach Anspruch 1, wobei das Diisozyanat-Monomer 1,3-bis(1-isozyanat-1-methylethyl)benzol ist und wobei das Diamin-Monomer 1,3-bis(aminomethyl)cyclohexan ist.

**3.** Verfahren zur Herstellung eines Polyharnstofffilms nach Anspruch 1, wobei das Diisozyanat-Monomer 1,3-bis(isozyanatmethyl)cyclohexan ist und wobei das Diamin-Monomer irgendeines von Methylenbis(4-cyclohexylamin), N,N-bis(3-aminopropyl)piperazin, 1,12-diaminododecan und 1,3-bis(aminomethyl)benzol ist.

**4.** Verfahren zur Herstellung eines Polyharnstofffilms nach Anspruch 1, wobei das Diisozyanat-Monomer 1,3-bis(isozyanatmethyl)benzol ist und wobei das Diamin-Monomer 1,12-diaminododecan ist.

## Revendications

**1.** Procédé de préparation d'un film de polyurée par polymérisation par dépôt sous vide d'un monomère diisocyanate d'alkyle aromatique, diisocyanate alicyclique ou diisocyanate aliphatique, et d'un monomère (alkyl aromatique)diamine, diamine alicyclique ou diamine aliphatique, où
la perte de poids des monomères lorsqu'ils sont chauffés sous vide est mesurée pour déterminer une pression de vapeur saturante P (unité : Pa) à une température T (unité : K) d'une surface de vaporisation d'après l'équation suivante :

$$P = 228{,}3m(T/M)^{1/2}$$

où m est une vitesse de vaporisation (dΔW/dt)/U, U est une aire au point de vaporisation, et M est une masse molaire des molécules en vaporisation ;
où une énergie d'activation ΔH requise pour l'élimination et un temps de rétention $\tau$ (s) des monomères sur un substrat sont déterminés d'après les équations suivantes :

$$\log P = A - \Delta H/RT$$
$$\tau = \tau_0 \exp(Ed/RT)$$

où R est une constante des gaz et $\tau_0$ vaut 4,6 x $10^{-17}$ ; et
les monomères individuels sont choisis de façon à satisfaire une relation telle que la différence d'énergie d'activation ΔH requise pour l'élimination du substrat entre le monomère diisocyanate et le monomère diamine est de 10 kJ ou moins.

**2.** Procédé de préparation d'un film de polyurée selon la revendication 1, dans lequel le monomère diisocyanate est

le 1,3-bis(1-isocyanate-1-méthyléthyl)benzène et le monomère diamine est le 1,3-bis(aminométhyl)cyclohexane.

3. Procédé de préparation d'un film de polyurée selon la revendication 1, dans lequel le monomère diisocyanate est le 1,3-bis(isocyanateméthyl)cyclohexane et le monomère diamine est n'importe lequel des méthylènebis(4-cyclohexylamine), N,N-bis(3-aminopropyl)pipérazine, 1,12-diaminododécane et 1,3-bis(aminométhyl)benzène.

4. Procédé de préparation d'un film de polyurée selon la revendication 1, dans lequel le monomère diisocyanate est le 1,3-bis(isocyanateméthyl)benzène et le monomère diamine est le 1,12-diaminododécane.

Fig. 1

(a)

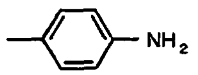

aromatic amine as terminal group (aniline)

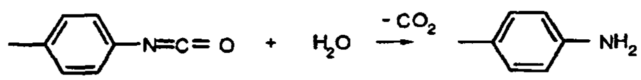


aromatic isocyanate as terminal group

aniline

(b)

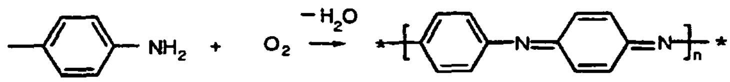


aniline

aniline black

Fig. 2

(a)

(b)

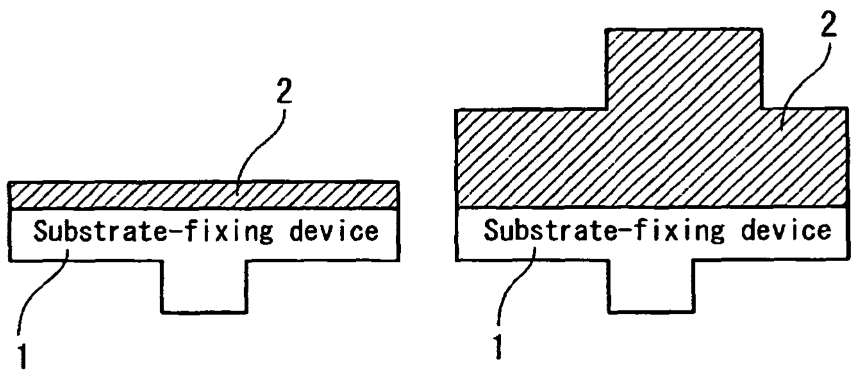

Fig. 3

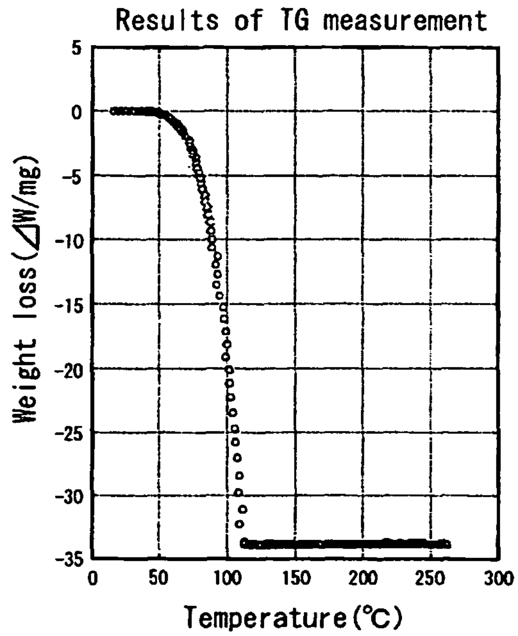
Results of TG measurement
Weight loss (⊿W/mg)
5
0
-5
-10
-15
-20
-25
-30
-35
0
50
100
150
200
250
300
Temperature (℃)

Fig. 4

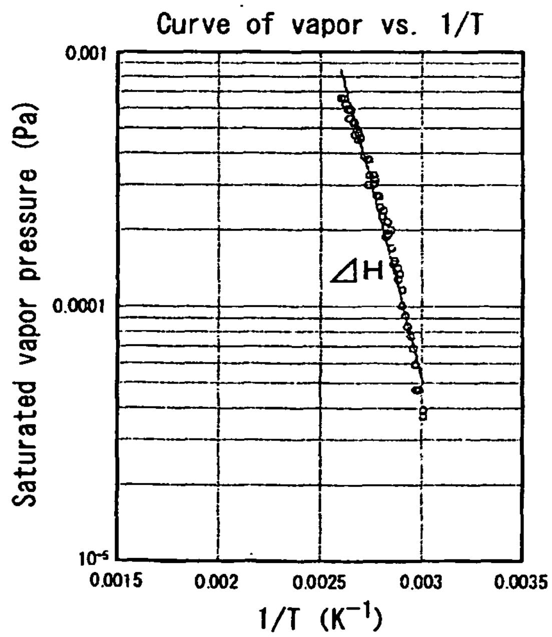
Curve of vapor vs. 1/T
Saturated vapor pressure (Pa)
0.001
0.0001
$10^{-5}$
⊿H
0.0015
0.002
0.0025
0.003
0.0035
1/T ($K^{-1}$)

Fig. 5

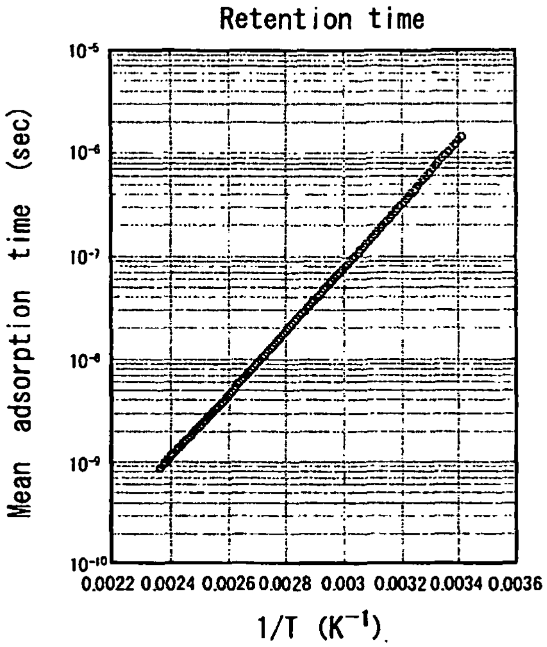
Retention time
Mean adsorption time (sec)
10⁻⁵
10⁻⁶
10⁻⁷
10⁻⁸
10⁻⁹
10⁻¹⁰
0.0022 0.0024 0.0026 0.0028 0.003 0.0032 0.0034 0.0036
1/T (K⁻¹)

Fig. 6

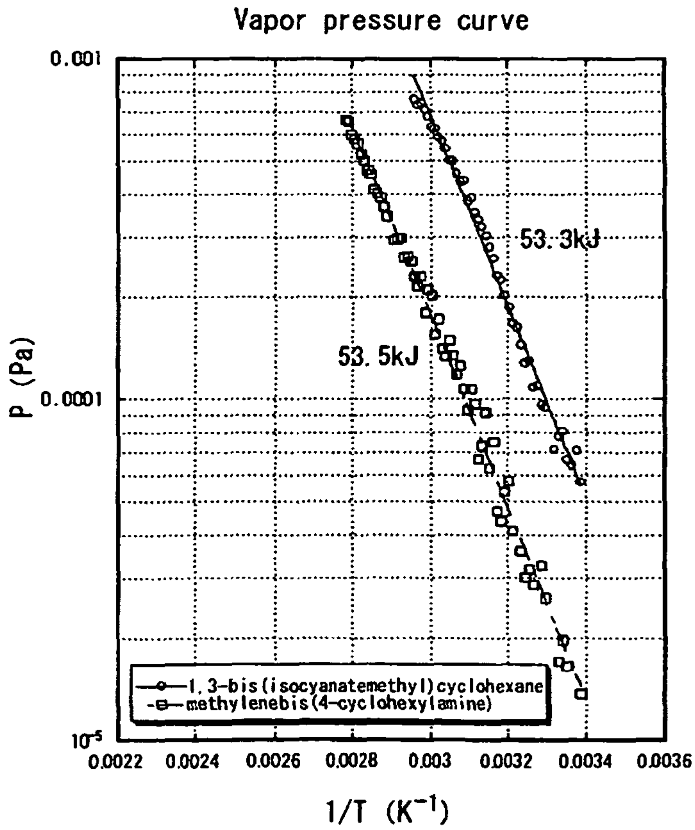
Vapor pressure curve
P (Pa)
0.001
0.0001
10⁻⁵
53.3kJ
53.5kJ
1,3-bis(isocyanatemethyl)cyclohexane
methylenebis(4-cyclohexylamine)
0.0022 0.0024 0.0026 0.0028 0.003 0.0032 0.0034 0.0036
1/T (K⁻¹)

Fig. 7

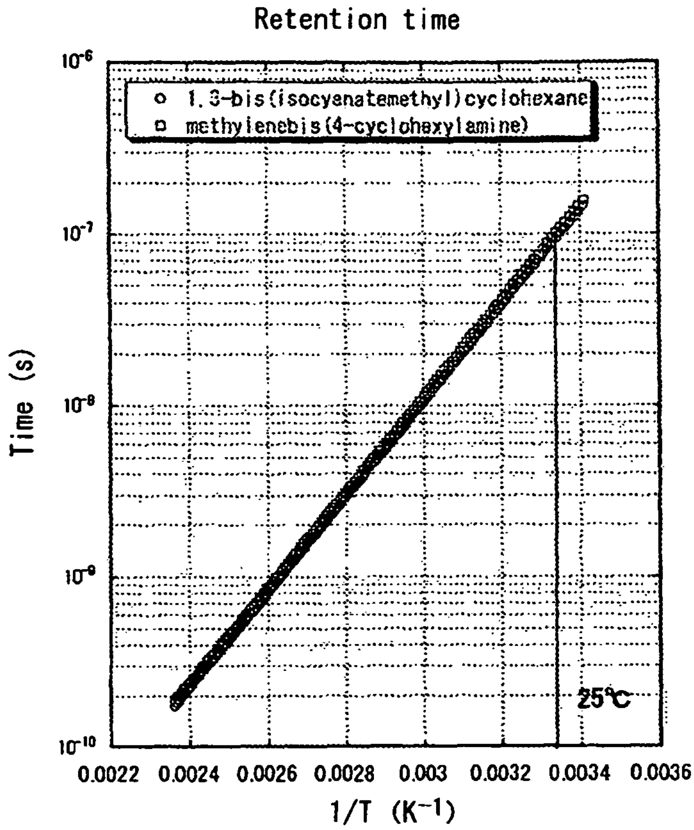
Retention time
1,3-bis(isocyanatemethyl)cyclohexane
methylenebis(4-cyclohexylamine)
Time (s)
10-6
10-7
10-8
10-9
10-10
25℃
0.0022 0.0024 0.0026 0.0028 0.003 0.0032 0.0034 0.0036
1/T (K-1)

Fig. 8

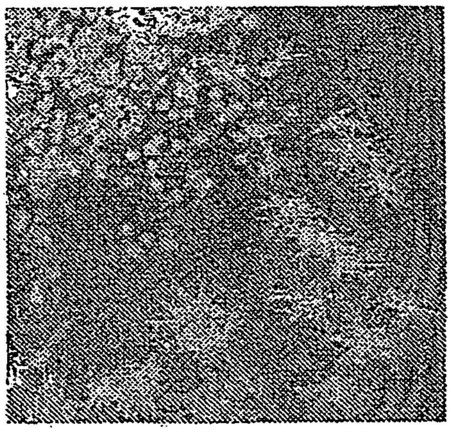

Fig. 9

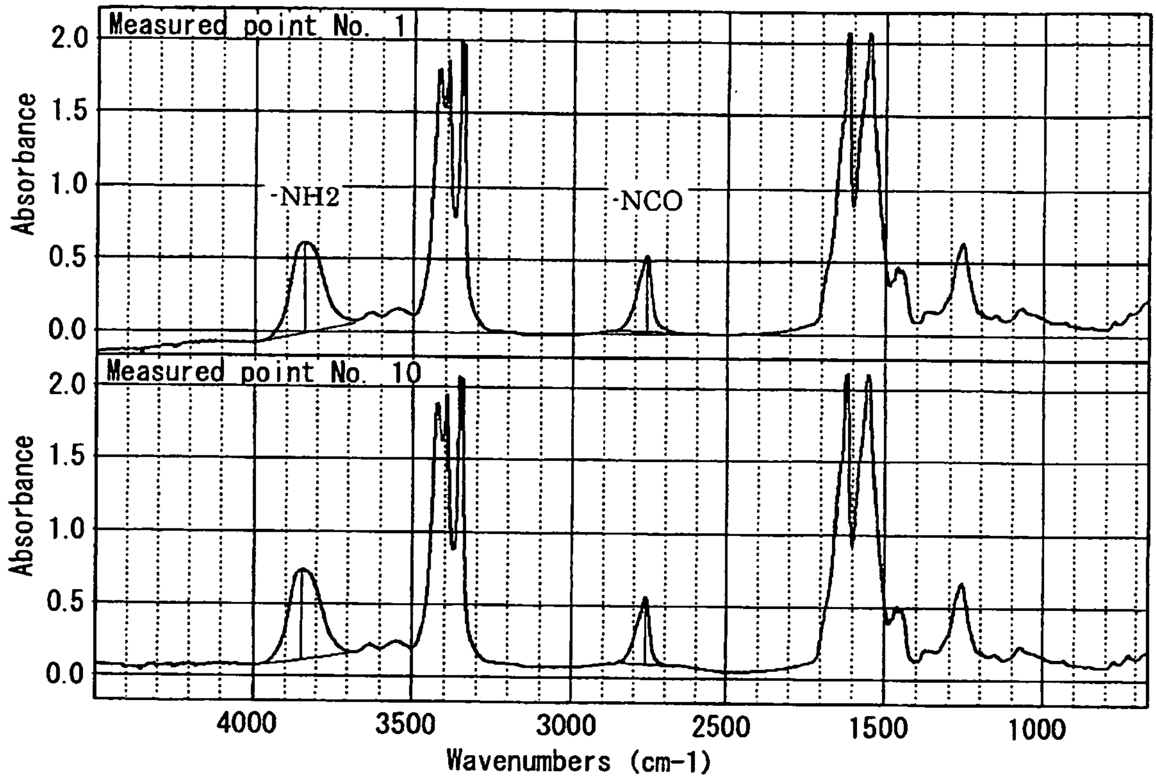
Measured point No. 1
2.0
1.5
1.0
0.5
0.0
Absorbance
-NH2
-NCO
Measured point No. 10
2.0
1.5
1.0
0.5
0.0
Absorbance
4000
3500
3000
2500
1500
1000
Wavenumbers (cm-1)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 61078463 A
- JP 3097849 A
- JP 8283932 A
- JP 9278805 A


### Non-patent literature cited in the description


- Vapor Pressure and Mean Adsorption Time of PMDA and ODA. *Japanese Journal of Applied Physics,* 1999, vol. 38